# EUROPEAN PATENT SPECIFICATION

(11) **EP 2 522 035 B1**
(45) Date of publication and mention of the grant of the patent: **20.11.2013**
(21) Application number: 11701872.1
(22) Date of filing: 05.01.2011
(51) Int. Cl.: H01L 31/0224, H01L 31/0352, H01L 31/18, H01L 31/20

(54) **SOLAR CELL AND METHOD FOR MANUFACTURING OF SUCH A SOLAR CELL**
SOLARZELLE UND VERFAHREN ZUR HERSTELLUNG EINER DERARTIGEN SOLARZELLE
CELLULE SOLAIRE ET SON PROCÉDÉ DE FABRICATION

(30) Priority: 06.01.2010 NL 2004066
(43) Date of publication of application: 14.11.2012
(73) Proprietor: Stichting Energieonderzoek Centrum Nederland, 1755 LE Petten (NL)
(72) Inventor: van Roosmalen, Johannes Adrianus Maria, NL-1755 LE Petten (NL); Geerligs, Lambert Johan, NL-1755 LE Petten (NL); Bronsveld, Paula Catharina Petronella, NL-1755 LE Petten (NL)
(74) Representative: Nederlandsch Octrooibureau
(86) International application number: PCT/NL2011/050005
(87) International publication number: WO 2011/084054

(56) References cited:
- EP-A2- 2 086 015
- TUCCI M ET AL: "Back contacted a-Si:H/c-Si heterostructure solar cells", JOURNAL OF NON-CRYSTALLINE SOLIDS, NORTH-HOLLAND PHYSICS PUBLISHING. AMSTERDAM, NL LNKD- DOI:10.1016/J.JNONCRYSOL.2007.09.023, vol. 354, no. 19-25, 1 May 2008 (2008-05-01), pages 2386-2391, XP022621486, ISSN: 0022-3093 [retrieved on 2008-02-05]
- STANGL R ET AL: "Planar rear emitter back contact silicon heterojunction solar cells", SOLAR ENERGY MATERIALS AND SOLAR CELLS, ELSEVIER SCIENCE PUBLISHERS, AMSTERDAM, NL, vol. 93, no. 10, 1 October 2009 (2009-10-01), pages 1900-1903, XP026459911, ISSN: 0927-0248 [retrieved on 2009-08-13]

## Description

### Field

The present invention relates to a solar cell. Also, the present invention relates to a method for manufacturing such a solar cell.

### Background

From the prior art, high efficiency silicon solar cells are known. To obtain a relatively high efficiency for conversion of radiation energy into electric energy, in such high efficiency cells the contacts of the minority charge carriers and the majority charge carriers have been arranged on the rear surface of the solar cell, while the front surface that is arranged for capturing the radiation energy, is kept free from any conductor(s) and/or contact(s) that would shadow the semiconductor material of the solar cell and reduce the capture of radiation by the solar cell.

Such a back-contacted" solar cell is known from e.g., Tucci et al., "Back Enhanced Heterostructure with INterDigitated contact -BEHIND- solar cell", IUMRS-ICEM 2008 International Conference on Electronic Materials 2008, Sydney, Australia, 28 July 2008 - 1 August 2008. Document by M. Tucci et al, Journal of non-crystalline Solids, 354(2008), p.2386-2391 describes a solar cell.

The prior art solar cell comprises interdigitated positive and negative contacts on the rear surface of the substrate. Both the positive contact type and the negative contact type are arranged as heterojunction structures, that comprise an intrinsic semiconductor material layer and a doped semiconductor material layer. The conductivity type of the positive contacts is opposite to the conductivity type of the negative contacts.

To obtain the interdigitated structure of positive and negative contacts, the method for manufacturing the prior art solar cell comprises a first deposition of one type heterostructure in blanket mode, covering substantially the rear surface. Next, a mask is arranged on the rear surface. Through the openings in the mask portions of the one type heterostructure are removed by dry etching. While the mask is still in place, the other type heterostructure structure is deposited on the rear surface through the openings of the mask. The resolution of the interdigitation method is relatively low due to the shadowing effects from the mask. As a result, the sizes of the positive and negative contacts can not be defined very precisely. This may adversely affect the collection efficiency of at least the minority charge carriers as well as the resistance against recombination of majority and minority charge carriers.

A potential problem of the behind concept is that is already difficult to collect all current through the heterojunction surface area if the full surface area is used. If only a small proportion of the surface is used, like for the majority carrier contacts, all current has to go through a smaller available surface.

It is an object of the invention to reduce or remove one or more of the disadvantages from the prior art.

The object is achieved by a solar cell as recited in claim 1.

Advantageously, the highly doped silicon layer acting as front surface field layer facilitates an improved ohmic conductance path for the majority charge carriers towards the corresponding electric contacts on the rear surface. The flow of the majority charge carriers is virtually concentrated in this ohmic conductance path. As a result the recombination of minority charge carriers and majority charge carriers in the bulk of the substrate and ohmic losses of the majority carriers are reduced significantly.

According to an aspect of the invention there is provided a solar cell as described above, wherein the heterostructure of the first type comprises a semiconductor material layer of a second conductivity type, the second conductivity type being opposite to the first conductivity type, wherein the semiconductor material layer of the second conductivity type is located on the rear surface of the substrate.

According to an aspect of the invention there is provided a solar cell as described above, wherein the heterostructure of the first type comprises an intrinsic semiconductor layer and a semiconductor material layer of a second conductivity type, the second conductivity type being opposite to the first conductivity type, wherein the intrinsic semiconductor layer is located on the rear surface of the substrate and the semiconductor material layer of the second conductivity type is located on top of the intrinsic semiconductor layer.

According to an aspect of the invention there is provided a solar cell as described above, wherein the intrinsic semiconductor layer is a layer of intrinsic amorphous silicon.

According to an aspect of the invention there is provided a solar cell as described above wherein the heterostructure of the first type comprises a dielectric layer and a semiconductor material layer of a second conductivity type, the second conductivity type being opposite to the first conductivity type, wherein the dielectric layer is located on the rear surface of the substrate and the semiconductor material layer of the second conductivity type is located on top of the dielectric layer.

According to an aspect of the invention there is provided a solar cell as described above, wherein the semiconductor material layer of the second conductivity type is a doped amorphous silicon layer of the second conductivity type.

According to an aspect of the invention there is provided a solar cell as described above, wherein the front surface field layer has a lateral modulation of the resistivity, comprising resistance regions of different resistance as a function of location in the front surface field layer.

According to an aspect of the invention there is provided a solar cell as described above, wherein the lateral modulation of the resistivity is embodied by a series of first zones and second zones in the front surface arranged in alternation adjacent to each other, each first zone having a lower resistance and each second zone having a relatively higher resistance.

According to an aspect of the invention there is provided a solar cell as described above, wherein the lateral modulation of the resistivity is embodied by the front surface field layer comprising a base layer and local doped areas, the base layer extending along the front surface of the substrate, the local doped areas being arranged along the base layer, the base layer having a base resistance, the combination of base layer and local doped area having a relatively lower resistance than the base layer's base resistance.

According to an aspect of the invention there is provided a solar cell as described above, wherein the second electric contacts are each embodied by a highly doped area in between a pair of first electric contacts; the highly doped area having the first conductivity type.

According to an aspect of the invention there is provided a solar cell as described above, wherein each second electric contact is arranged within openings of the intrinsic semiconductor layer and the semiconductor material layer of the second conductivity type of adjacent first electric contacts.

According to an aspect of the invention there is provided a solar cell as described above, wherein the opening in the intrinsic semiconductor layer of the first electric contacts is equal to the opening in the semiconductor material layer of the second conductivity type of the first electric contacts.

According to an aspect of the invention there is provided a solar cell as described above, wherein the openings in the intrinsic semiconductor layer and the semiconductor material layer are equal to a width of the second electric contact.

According to an aspect of the invention there is provided a solar cell as described above, wherein the opening in the intrinsic semiconductor layer of the first electric contacts is smaller than the opening in the semiconductor material layer of the second conductivity type of the first electric contacts, and the opening in the intrinsic semiconductor layer is equal to a width of the second electric contact.

According to an aspect of the invention there is provided a solar cell as described above, wherein the openings in the intrinsic semiconductor layer and the semiconductor material layer are larger than a width of the second electric contact.

According to an aspect of the invention there is provided a solar cell as described above, wherein the opening in the intrinsic semiconductor layer of the first electric contacts is equal to the opening in the semiconductor material layer of the second conductivity type of the first electric contacts, and a width of the second electric contact is larger than the openings in the intrinsic semiconductor layer and the semiconductor material layer.

According to an aspect of the invention there is provided a solar cell as described above, wherein the opening in the intrinsic semiconductor layer of the first electric contacts is smaller than a width of the second electric contact and the opening in the semiconductor material layer of the second conductivity type of the first electric contacts is larger than the opening in the intrinsic semiconductor layer.

According to an aspect of the invention there is provided a solar cell as described above, wherein the opening in the semiconductor material layer of the second conductivity type is equal to the width of the second electric contact.

According to an aspect of the invention there is provided a solar cell as described above, wherein the opening in the semiconductor material layer of the second conductivity type is larger than the width of the second electric contact.

According to an aspect of the invention there is provided a solar cell as described above, wherein the opening in the intrinsic semiconductor layer of the first electric contacts is equal to the opening in the semiconductor material layer of the second conductivity type of the first electric contacts and the openings in the intrinsic semiconductor layer and the semiconductor material layer are either equal to, or smaller or larger than a width of the second electric contact, wherein a portion of the area of the second electric contact is covered by a passivation layer.

According to an aspect of the invention there is provided a solar cell as described above, wherein the passivation layer comprises a passivating material selected from a group consisting of silicon nitride, aluminum oxide, silicon dioxide and amorphous silicon or stacks or combinations thereof.

According to an aspect of the invention there is provided a method for manufacturing a solar cell, as described in claim 22.

According to an aspect of the invention there is provided a method as described above, wherein the front surface field layer is arranged to have a lateral modulation of the resistivity, comprising resistance regions of different resistance as a function of location in the front surface field layer.

Further embodiments are defined in the dependent claims appended to this application.

Below, the invention will be explained with reference to some drawings, which are intended for illustration purposes only and not to limit the scope of protection as defined in the accompanying claims.

### Brief description of drawings

Figure 1 shows a cross-section of a solar cell in accordance with a first embodiment;
Figure 2 shows a plane view of the front surface of the solar cell according to an embodiment;
Figures 3a-3b show cross-sections of a solar cell in accordance with a second embodiment;
Figure 4 shows a cross-section of a solar cell in accordance with a third embodiment, Figures 5a, 5b schematically show a plane view of the rear surface of a solar cell according to the present invention;
Figures 6a - 6c show a cross section of a detail of a solar cell according to the present invention;
Figures 7a - 7c show a cross section of a detail of a solar cell according to the present invention; and
Figures 8a - 8c show a cross section of a detail of a solar cell according to the present invention.

### Detailed description

The present invention recognizes that to improve the efficiency of a back-contacted solar cell the area for collection of the minority charge carriers should be relatively large in comparison to the area of collection for the majority charge carriers. In this manner, collection efficiency of the minority charge carriers is enhanced. Additionally, by a larger area of the collection for the minority charge carriers, the distance between two contacts for majority charge carriers collection is enlarged. This reduces the overall recombination loss of the solar cell, but may result in some increase of the resistance.

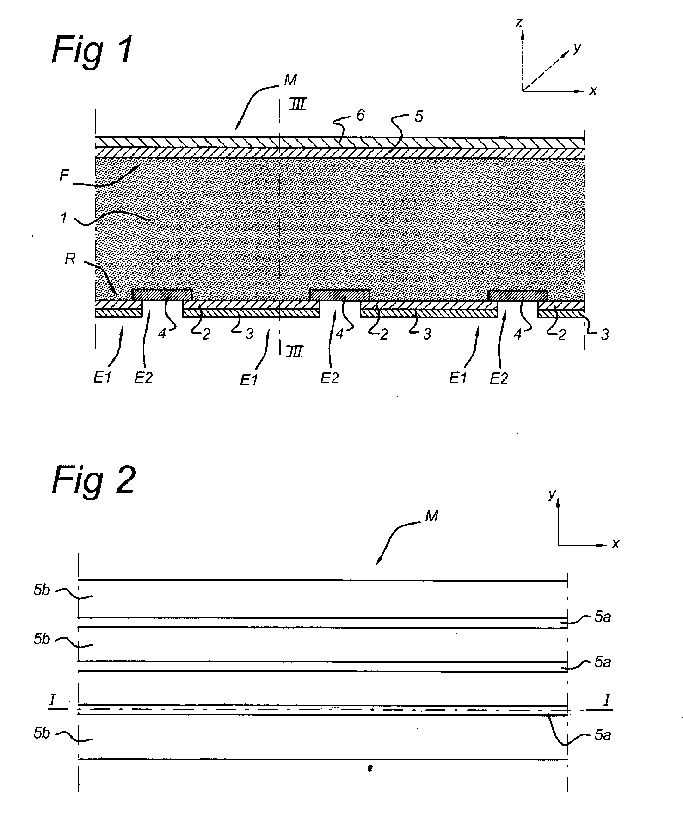

Figure 1 shows a cross-section of a solar cell in accordance with a first embodiment of the invention. A solar cell M comprises a silicon semiconductor substrate 1. The silicon semiconductor substrate 1 has been slightly doped with suitable impurity atoms to obtain a bulk conductivity of first conductivity type. Depending on the type of impurity species the first conductivity type is either n-type for donor impurity (e.g., phosphor or arsenic), or p-type for acceptor impurity (e.g., boron or aluminium).

The silicon substrate has a front surface F and a rear surface R. The front surface will serve as the surface for capturing light from a radiation source such as the Sun.

On the rear surface R, a plurality of first and second electric contacts E1, E2 is arranged. In a first direction X, adjacent to each first electric contact E1, a second electric contact E2 is located and vice versa. The first electric contacts E1 and second electric contacts E2 may extend in a second direction Y, perpendicular to the first direction X and to the thickness direction Z of the substrate.

The first electric contact E1 is embodied as a first heterostructure 2, 3, that comprises an intrinsic silicon layer 2, typically amorphous silicon, and an impurity doped silicon layer 3, typically amorphous silicon. The intrinsic silicon layer 2 is located on the rear surface R of the silicon substrate 1 and the impurity doped silicon layer 3 is located on top of the intrinsic silicon layer 2. The impurity doped silicon layer has a conductivity of the second conductivity type, which is opposite to the first conductivity type. In this manner, the first electric contact is the contact for minority charge carriers.

In an alternative embodiment, the intrinsic silicon layer 2 may be replaced by a thin dielectric layer. The thin dielectric layer may comprise an oxide layer, in a further embodiment the thin dielectric layer may be a silicon dioxide layer.

Alternatively, the first electric contact E1 can be embodied without an intrinsic semiconductor layer 2 as an alternative heterostructure 3, that comprises an impurity doped silicon layer 3, typically amorphous silicon, wherein the impurity doped silicon layer 3 is located directly on top of the silicon semiconductor substrate 1 without the intermediate intrinsic silicon layer 2.

In the first embodiment, the second electric contacts E2 are embodied by highly doped areas in the silicon semiconductor substrate in between each two first electric contacts E1. The highly doped areas have a high dopant concentration relative to the dopant concentration of the substrate and have the same conductivity type as the conductivity type of the substrate, i.e., the first conductivity type.

Various processes may be used to create the first and second electric contacts on the rear surface.

One example of a process may comprise a deposition of a doped silicon nitride layer (or alternatively a doped amorphous silicon layer or silicon nitride layer or an amorphous silicon layer or silicon oxide layer or other passivating layers with a dopant source deposited on top of them) on the rear surface which by laser irradiation is locally heated. During the heating a doped area is created in the rear surface at the location of the heating by diffusion of dopant from the doped silicon nitride or silicon oxide or amorphous silicon layer or other passivating layers or the source on top of such a layer, while at the same time the silicon nitride (silicon oxide or amorphous silicon or other passivating layers) is ablated by the laser.

A further example may comprise a deposition of a doped amorphous silicon layer which is selectively removed by patterning whereafter a dopant source is applied that is heated locally (e.g. by laser) to form doped areas in the rear surface. The selective removal may be done by laser ablation, mechanical removal (scribing), selective and/or masked etching, wet or dry.

In a further example the process may comprise a masked deposition of amorphous silicon of the first conductivity type. The deposition of a doped (amorphous) silicon layer is masked, while as a result of the formation of the heterojunction the intrinsic amorphous silicon layer is already present on the entire rear surface, for providing surface passivation. In this further example, the prior deposition of amorphous silicon of the first conductivity type is also masked or that layer is locally removed selectively, leaving the intrinsic layer underneath practically intact.

Alternatively the process may comprise to provide the silicon rear surface with (selectively applied) locally diffused contact regions (from a high temperature process) before the application of an amorphous silicon layer followed by local removal of the amorphous silicon to obtain a patterned amorphous silicon layer or before the application of a patterned amorphous silicon layer obtained by masked a-Si deposition. Providing the silicon surface with (selectively applied) locally diffused contact regions is not a single step process as will be appreciated by the skilled in the art.

On the front surface F, the silicon substrate comprises a highly doped layer 5 and a coating layer 6.

The highly doped layer 5, also of the first conductivity type, is located on the front surface of the silicon substrate 1. On top of the highly doped layer 5, the coating layer 6 is located.

The highly doped layer 5 may be formed in various ways known to the skilled person: for example by deposition or by in-diffusion of a dopant species of the first conductivity type or by a reaction of the dopant species with the surface of the silicon substrate or by ion implantation.

In an embodiment, the highly doped layer 5 uniformly covers the front surface of the substrate.

The coating layer 6 comprises one or more layers that provide anti-reflection and passivation of the surface and texturing of the surface is also included.

The highly doped layer 5 serves as a front surface field (FSF) layer that is arranged to reduce the lateral resistance of the front surface and to reduce or minimize front surface recombination. In this manner, an ohmic conductance path for the majority charge carriers along the front surface is created. The majority charge carriers are thus allowed to travel to areas substantially above the second electric contacts E2 on the rear surface and to cross the bulk of the silicon substrate along a shortest path perpendicular to the surfaces of the substrate. Thus, the main conductance path comprises a lateral path to the area above the second electric contact and the path to cross the substrate, i.e., substantially the thickness of the substrate. The conductance follows Ohms law as will be appreciated by the skilled person.

By providing the lateral path with relatively low resistance along the front surface, the present invention allows that the distance between each two second electric contacts for majority charge carriers can be enlarged and the area of the first electric contact as minority charge carrier in between the two second electric contact can be enlarged as well and/or (much) thinner cells can be used.

By providing highly doped areas 4 as second electric contact E2, the maximum allowable current density in these areas 4 can be relatively high in comparison to second electric contacts made of first heterostructure areas. As a result for the same current the second electric contact made of highly doped area can be smaller than a heterostructure area. Additionally, it is noted that processes to create highly doped areas 4, have a relatively high resolution allowing creating contacts with relatively small size at relatively high accuracy.

Advantageously, both the enhanced conductance path by the front surface field layer and the use of highly doped areas as second electric contacts thus allow larger areas for the first electric contact to collect minority charge carriers. Also, the larger distance between second electric contacts reduces the overall recombination and ohmic losses.

Figure 2 shows a plane view of the front surface of a solar cell according to the present invention.

By creating a front surface field layer 5, a trade-off between a relatively higher conductance and a relatively higher recombination loss will occur. This trade off can be influenced by locally altering the dopant impurity level of the front surface field layer 5. This result in a) regions with a higher overall conductance which causes a relatively higher recombination loss but allows a relatively larger distance between electric contacts for majority charge carriers, i.e. the second electric contacts E2, and b) regions with lower conductance and relatively lower recombination loss. Since the area for the majority charge carrier contacts (second electric contacts E2) can be kept small in comparison to the area for minority charge carrier contacts (first electric contacts E1), an overall gain in efficiency is possible in comparison to a uniformly doped front surface field layer 5.

In the embodiment shown here, the front surface field layer 5 comprises resistance regions 5a, 5b of different resistance as a function of the location in the front surface field layer 5.

The regions 5a have relatively low resistance while the regions 5b have relatively high resistance. By modulating the resistance regions in a direction Y perpendicular to the first direction X in which first electric contacts E1 alternate with second electric contacts E2, the conductance path of the majority charge carriers to cross the thickness of the substrate perpendicularly above the second electric contacts towards the second electric contacts E2 is further improved. The resistance regions are finger shaped and extend along the front surface in the first direction X.

Dashed line I-I indicates the cross-section of the solar cell as shown in figure 1.

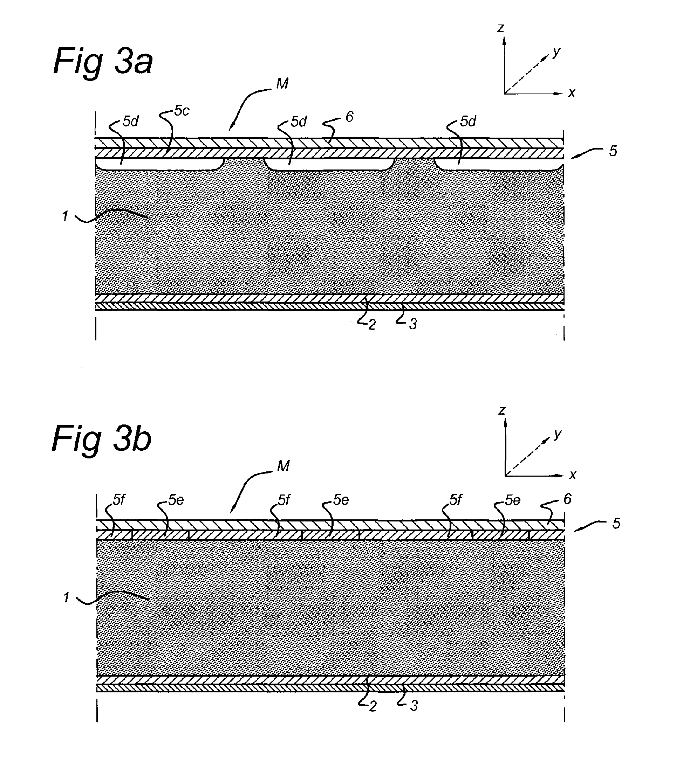

Figures 3a-3b show cross-sections of a solar cell in accordance with a second embodiment along dashed line III-III shown in figure 1.

In Figures 3a-3b entities with the same reference number as shown in the preceding figures refer to corresponding entities. For a detailed description of these entities referral is made to figures 1 and 2 and their description.

In the second embodiment, the front surface field layer 5 comprises resistance regions 5c, 5d; 5e, 5f of different resistance as a function of the location in the front surface field layer 5. By modulating the resistance regions in the second direction Y the conductance path of the majority charge carriers to cross the thickness of the substrate perpendicularly above the second electric contacts towards the second electric contacts E2 is further improved.

The location of the resistance regions in the front surface field layer do not necessarily coincide with the location of the first and second electric contacts in the rear surface. In the second embodiment, on the rear surface R of the silicon substrate, a plurality of first and second electric contacts E1, E2 is arranged. Adjacent to each first electric contact E1, a second electric contact E2 is located. Each first electric contact E1 is embodied as the first heterostructure 2, 3. Each second electric contact E2 is embodied by the highly doped area in between each two first electric contacts E1.

Figure 3a shows an example of the second embodiment in which the front surface field layer 5 comprises a base layer 5c with base resistance and local doped areas 5d.

The base layer 5c substantially extends in the second direction Y along the front surface of the substrate. By the combination of the base layer 5d and the local doped area 5c, locally the resistance is reduced.

Figure 3b shows an example of the second embodiment in which the front surface field layer 5 is modulated along the second direction Y by a series of first zones 5e and second zones 5f arranged next to each other in alternation. The first zones 5e are arranged to have a lower resistance and the second zones 5f to have a relatively higher resistance.

The modulation of first and second zones may be obtained by using a patterned diffusion source layer, e.g. a dopant containing glass or silicate layer and/or by driving in dopants locally by means of a laser and/or by selective etch back.

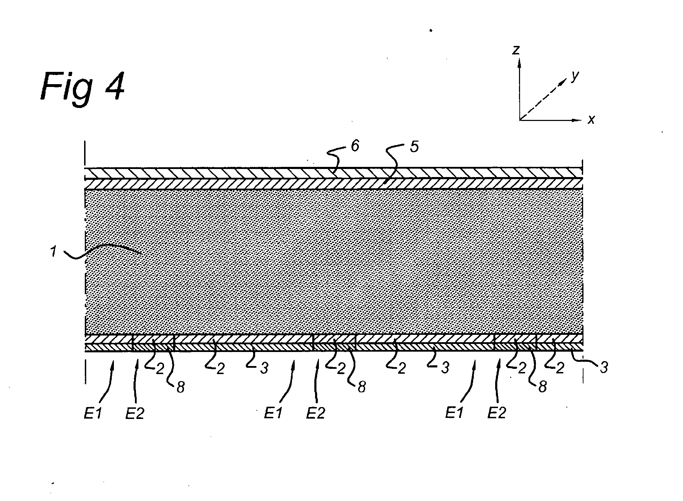

Figure 4 shows a cross-section of a solar cell in accordance with a third embodiment.

In the third embodiment, the second electric contacts E2 are embodied as a second heterostructure 2, 8, that comprises an intrinsic silicon layer 2, typically amorphous silicon, and a second impurity doped silicon layer 8, typically amorphous silicon. The intrinsic silicon layer 2 is located on the rear surface R of the silicon substrate 1 and the second impurity doped silicon layer 8 is located on top of the intrinsic silicon layer 2. The second impurity doped silicon layer 8 has a conductivity of the first conductivity type. In this manner the second heterostructure 2,8 has a conductivity type opposite to that of the first heterostructure 2, 3. The second electric contact E2 is thus a contact for majority charge carriers.

In this embodiment, the front surface field layer may be modulated as described with reference to either figure 3a or figure 3b.

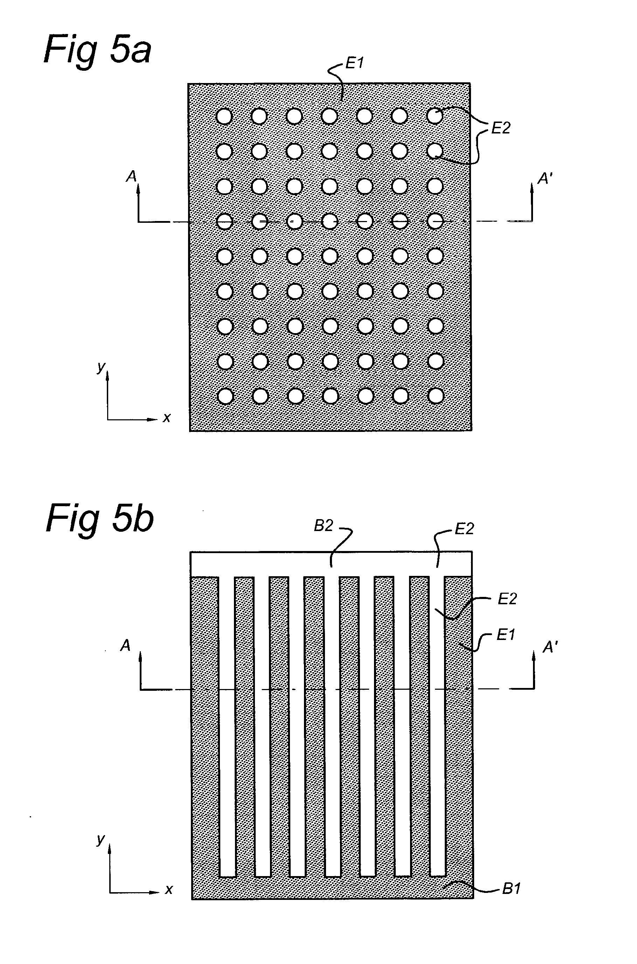

Figure 5a schematically shows a plane view of the rear surface R of a solar cell according to the present invention comprising a first contact scheme.

On the rear surface R the solar cell comprises first electric contact E1 and second electric contacts E2. In the embodiment of figure 5a, the second electric contacts E2 that act as electrodes for majority charge carriers are arranged as dots, while the first electric contacts E1 are embodied as a layer covering the remainder of the rear surface. The surface area covered by the second electric contacts E2 is relatively smaller than the area covered by the first electric contacts E1. In this manner, the loss by recombination is reduced and the efficiency of the solar cell is enhanced.

On the surface of both electric contacts E1 and E2 a conductive layer is located (not shown). The conductive layer is interrupted between the electric contacts E1 and E2 to isolate both contacts from each other. The interrupting element may be one of a slit (or gap) or an isolation element. The isolation element typically comprises an insulating (or dielectric) material. The conductive layer may comprise a metallic layer (e.g., aluminum and/or silver) and/or a transparent conductive oxide layer (such as indium-tin-oxide or zinc oxide).

An additional layer (not shown) may be arranged on top of the first and second electric contacts to provide additional conductivity for the second electric contacts E2. The additional layer is isolated from the first electric contacts E1. The additional layer may be patterned.

In this embodiment, dashed line A-A' indicates the cross-section of the solar cell as shown in any one of the figures 1 - 4 along the first direction X.

Figure 5b schematically shows a plane view of the rear surface of a solar cell according to the present invention.

On the rear surface R the solar cell comprises first electric contact E1 and second electric contacts E2. In the embodiment of figure 5b, the second electric contacts E2 that act as electrodes for majority charge carriers and the first electric contact E1 are arranged as an interdigitated structure, in which the first electric contacts E1 are interconnected by a first bar B1 and the second electric contacts E2 are interconnected by a second bar B1. The surface area covered by the second electric contacts E2 is relatively smaller than the area covered by the first electric contacts E1. In this manner, the loss by recombination is reduced and the efficiency of the solar cell is enhanced. On the surface of both electric contacts E1 and E2 a conductive layer is located (not shown). The conductive layer is interrupted between the electric contacts E1 and E2 to isolate both contacts from each other. The interrupting element may be one of a slit (or gap) or an isolation element. The isolation element typically comprises an insulating (or dielectric) material. The conductive layer may comprise a metallic layer (e.g., aluminum and/or silver) and/or a transparent conductive oxide layer (such as indium-tin-oxide or zinc oxide).

An additional layer (not shown) may be arranged on top of the first and second electric contacts to provide additional conductivity for the second electric contacts E2. The additional layer is isolated from the first electric contacts E1. The additional layer may be patterned.

In this embodiment, dashed line B-B' indicates the cross-section of the solar cell as shown in any one of the figures 1 - 4 along the first direction X.

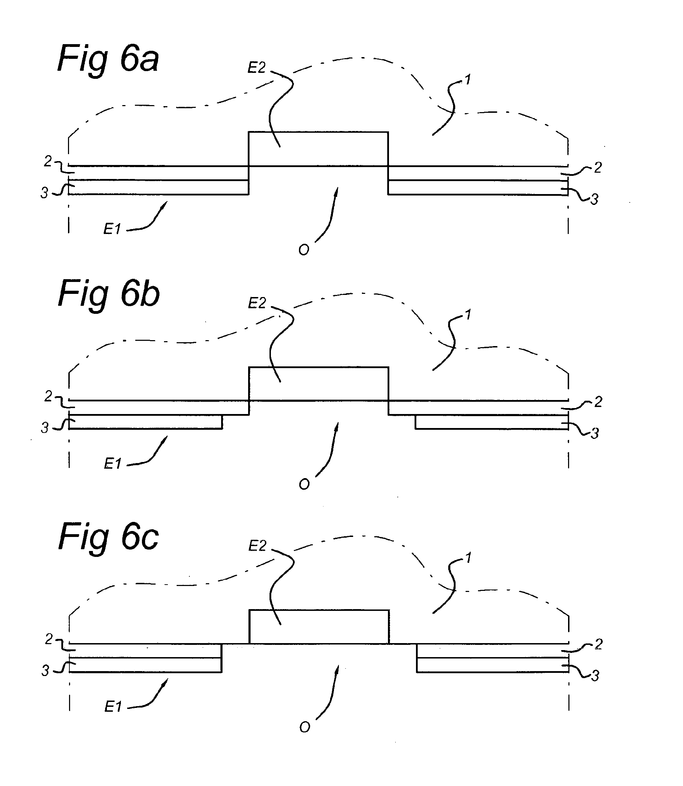

Figures 6a - 6c show a cross section of a detail of a solar cell according to the present invention.

Figures 6a - 6c show the arrangement of the first and second electric contacts when the method for manufacturing the solar cell comprises a sequence in which the first electric contacts E1 are created before the highly doped second electric contacts E2 are created. After creation of the first electric contacts E1 by depositing first the intrinsic semiconductor layer 2 and then the semiconductor material of the second conductivity type, openings O are created (e.g. etched, ablated) and the second electric contacts E2 are created e.g. by laser assisted doping. Alternatively, the openings O may be created by masked deposition of layers 2 and/or 3.

Figure 6a shows a detailed cross-section for the situation that both the intrinsic and doped semiconductor layers 2, 3 are arranged to have the same opening and the second electric contact E2 is arranged to completely fill the opening O.

Figure 6b shows a detailed cross-section for the situation that the opening in the intrinsic semiconductor layer 2 is arranged to be smaller than the opening of the doped semiconductor layers and the second electric contact E2 is arranged to completely fill the opening O.

Figure 6c shows a detailed cross-section for the situation that the second electric contact is arranged to partially fill the opening in the intrinsic semiconductor layer and the doped semiconductor layer.

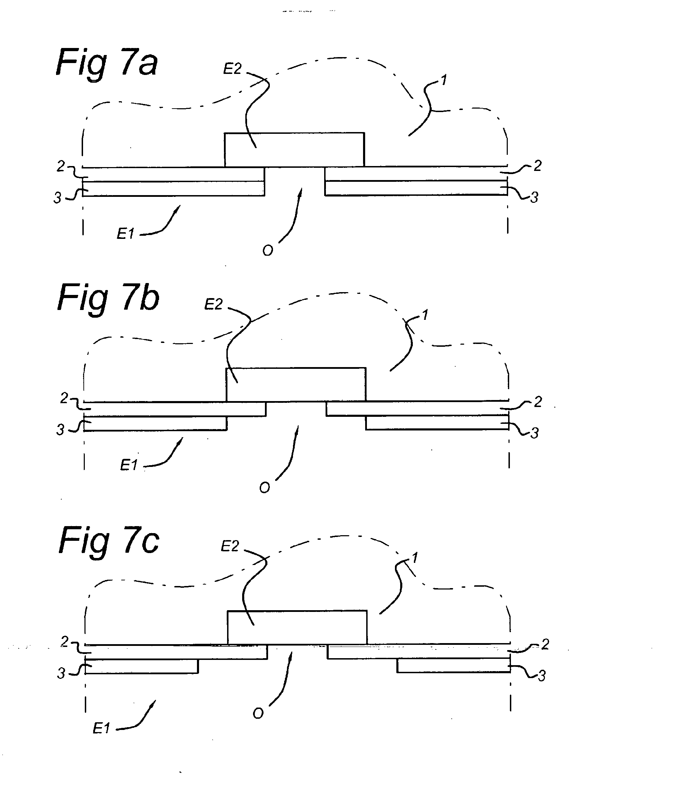

The same situations may occur when the method for manufacturing the solar cell comprises a sequence in which the first electric contacts E1 are created after highly doped second electric contacts E2 are created. Additionally the following situations as shown in figures 7a - 7c may occur.

Figures 7a - 7c show a cross section of a detail of a solar cell according to the present invention. The method for manufacturing the solar cell comprises a sequence in which the first electric contacts E1 are created after the highly doped second electric contacts E2 are created. In this sequence first the second electric contacts are created and then a layer of intrinsic semiconductor material 2 is deposited followed by the deposition of the semiconductor material layer 3 of the second conductivity type. After these depositions, an opening O is created over each second electric contact E2.

Figure 7a shows the situation in which the created opening is smaller than the size of the area of the second electric contact E2. Both the intrinsic and doped semiconductor layers 2, 3 have the same opening which is favorable for improved surface passivation.

Figure 7b shows the situation in which the created opening of the intrinsic semiconductor layer 2 is smaller than the size of the area of the second electric contact E2, while the opening in the doped semiconductor material layer 3 is substantially the same as the size of the area of the second electric contact E2. Again this arrangement is favorable for improved surface passivation.

Figure 7c shows the situation in which the created opening of the intrinsic semiconductor layer 2 is smaller than the size of the area of the second electric contact E2, while the opening in the doped semiconductor material layer 3 is larger as the size of the area of the second electric contact E2. The partial coverage of the second electric contact E2 by the intrinsic semiconductor layer 2 improves the surface passivation.

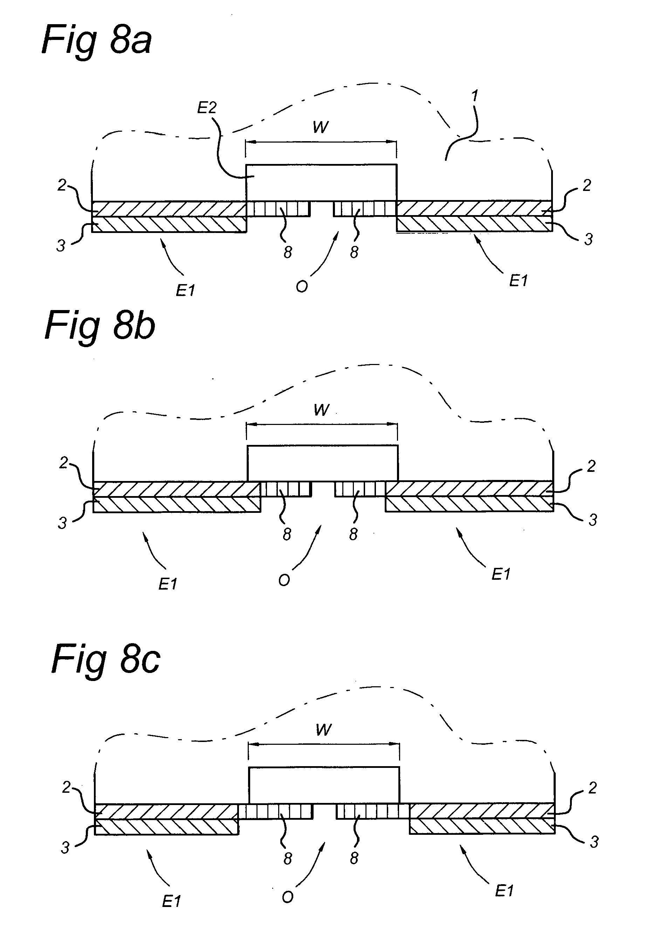

Figures 8a - 8c show a cross section of a detail of a solar cell according to the present invention. The method for manufacturing the solar cell comprises a sequence in which the first electric contacts E1 are created after the highly doped second electric contacts E2 are created. In this sequence first the second electric contacts are created and then a layer of intrinsic semiconductor material 2 such as amorphous silicon is deposited followed by the deposition of the semiconductor material layer 3 of the second conductivity type. After these depositions, an opening O is created over each second electric contact E2. The opening O can also be created by applying these depositions in combination with masking techniques.

Figure 8a shows the situation in which the created opening is substantially equal to the size of the width w of the second electric contact E2. Additionally, a portion of the created opening area is covered by a passivation layer 8 for surface passivation of the second electric contact E2 in such a way that an (center) area of the second electric contact E2 remains open and the remainder area of the second electric contact E2 (adjacent to the neighboring first electric contacts) is covered by the passivation layer.

The passivation layer 8 may consist of any known passivating material or combination of materials, e.g. stacked layers. Preferably, the passivating material is selected from silicon nitride (SiNₓ), aluminum oxide (Al₂O₃) and silicon dioxide. Also, the passivation layer may consist of amorphous silicon.

In case the intrinsic semiconductor material is amorphous silicon and the passivating material of the passivation layer is amorphous silicon, then a thickness of the passivation layer is different from (i.e., larger than) the thickness of the intrinsic semiconductor material layer 2.

Figure 8b shows the situation in which the created opening of the intrinsic semiconductor layer 2 and the layer of semiconductor material of the second conductivity type 3 is smaller than the size of the width w of the second electric contact E2. Additionally, a portion of the created opening area is covered by a passivation layer 8 for surface passivation of the second electric contact E2 in such a way that an (center) area of the second electric contact E2 remains open and the remainder area of the second electric contact E2 is covered by the passivation layer.

Figure 8c shows the situation in which the created opening of the intrinsic semiconductor layer 2 and the layer of semiconductor material of the second conductivity type is larger than the size of the width of the second electric contact E2. A portion of the created opening area is covered by a passivation layer 8 for surface passivation of the second electric contact E2 in such a way that an (center) area of the second electric contact E2 remains open and the remainder area of the created opening area is covered by the passivation layer 8.

In the embodiment shown in figures 8a- 8c, the passivating layer abuts the intrinsic semiconductor layer 2. It is noted that a small gap between the intrinsic semiconductor layer 2 and the passivating layer 8 may be present due to practical constraints such as a misalignment or a masking/shadowing effect. Likewise, a small overlap of the passivating layer 8 and the intrinsic semiconductor layer 2 may occur, wherein either the passivating layer overlaps the intrinsic semiconductor layer or vice versa.

As will be appreciated by the skilled person, the occurrence of either a small gap or an overlap will not significantly affect the passivation of the second electric contact.

## Claims

1. A solar cell (M) comprising a silicon semiconductor substrate (1) of a first conductivity type, the substrate having a front surface (F) and a rear surface (R); the front surface being arranged for capturing radiation energy;
the rear surface comprising a plurality of first electric contacts (E₁) and a plurality of second electric contacts (E₂), the first and second electric contacts being arranged in alternation adjacent to each other,
wherein each first electric contact is a heterojunction structure of a first type (2,3,3) as contact for minority charge carriers,
wherein the front surface of the silicon substrate comprises a lateral conductance path along the front surface for majority charge carriers, the lateral conductance path provided by a front surface field layer located on the front surface of the silicon substrate, the front surface field layer being a highly doped silicon layer (5; 5a, 5b; 5c, 5d; 5e, 5f), the conductivity of the front surface field layer being of the first conductivity type, in such a way that the lateral conductive path along the front surface provides a relatively low resistance to locations on the front surface substantially above corresponding second electric contacts (E₂) where the majority change carriers can traverse the substrate in a direction substantially perpendicular to the front surface towards said second electric contacts.

2. The solar cell according to claim 1, wherein the heterojunction structure of the first type comprises a semiconductor material layer (3) of a second conductivity type, the second conductivity type being opposite to the first conductivity type, wherein the semiconductor material layer (3) of the second conductivity type is located on the rear surface of the substrate.

3. The solar cell according to claim 1, wherein the heterojunction structure of the first type comprises an intrinsic semiconductor layer (2) and a semiconductor material layer (3) of a second conductivity type, the second conductivity type being opposite to the first conductivity type, wherein the intrinsic semiconductor layer (2) is located on the rear surface of the substrate and the semiconductor material layer (3) of the second conductivity type is located on top of the intrinsic semiconductor layer.

4. The solar cell according to claim 3, wherein the intrinsic semiconductor layer (2) is a layer of intrinsic amorphous silicon.

5. The solar cell according to claim 1, wherein the heterojunction structure of the first type comprises a dielectric layer and a semiconductor material layer (3) of a second conductivity type, the second conductivity type being opposite to the first conductivity type, wherein the dielectric layer is located on the rear surface (R) of the substrate and the semiconductor material layer (3) of the second conductivity type is located on top of the dielectric layer.

6. The solar cell according to any one of the preceding claims 2 - 5, wherein the semiconductor material layer (3) of the second conductivity type is a doped amorphous silicon layer of the second conductivity type.

7. The solar cell according to claim 1, wherein the front surface field layer has a lateral modulation of the resistivity, comprising resistance regions (5a;5b; 5c, 5d; 5e, 5f) of different resistance as a function of location in the front surface field layer.

8. The solar cell according to claim 7, wherein the lateral modulation of the resistivity is embodied by a series of first zones (5e) and second zones (5f) in the front surface arranged in alternation adjacent to each other, each first zone having a lower resistance and each second zone having a relatively higher resistance.

9. The solar cell according to claim 7, wherein the lateral modulation of the resistivity is embodied by the front surface field layer comprising a base layer (5c) and local doped areas (5d), the base layer extending along the front surface of the substrate, the local doped areas being arranged along the base layer, the base layer having a base resistance, the combination of base layer and local doped area having a relatively lower resistance than the base layer's base resistance.

10. The solar cell according to claim 1, wherein the second electric contacts are each embodied by a highly doped area (4) in the silicon semiconductor substrate in between a pair of first electric contacts; the highly doped area having the first conductivity type.

11. The solar cell according to claim 10 and claim 3, wherein each second electric contact (E₂) is arranged within openings (O) of the intrinsic semiconductor layer (2) and the semiconductor material layer (3) of the second conductivity type of adjacent first electric contacts (E₁).

12. The solar cell according to claim 11 wherein the opening in the intrinsic semiconductor layer (2) of the first electric contacts (E₁) is equal to the opening in the semiconductor material layer (3) of the second conductivity type of the first electric contacts (E₁).

13. The solar cell according to claim 12, wherein the openings in the intrinsic semiconductor layer and the semiconductor material layer are equal to a width of the second electric contact (E₂).

14. The solar cell according to claim 11, wherein the opening in the intrinsic semiconductor layer of the first electric contacts is smaller than the opening in the semiconductor material layer of the second conductivity type of the first electric contacts, and the opening in the intrinsic semiconductor layer is equal to a width (W) of the second electric contact.

15. The solar cell according to claim 12, wherein the openings in the intrinsic semiconductor layer and the semiconductor material layer are larger than a width of the second electric contact.

16. The solar cell according to claim 11 wherein the opening in the intrinsic semiconductor layer of the first electric contacts is equal to the opening in the semiconductor material layer of the second conductivity type of the first electric contacts, and a width of the second electric contact is larger than the openings in the intrinsic semiconductor layer and the semiconductor material layer.

17. The solar cell according to claim 11, wherein the opening in the intrinsic semiconductor layer of the first electric contacts is smaller than a width of the second electric contact and the opening in the semiconductor material layer of the second conductivity type of the first electric contacts is larger than the opening in the intrinsic semiconductor layer.

18. The solar cell according to claim 17, wherein the opening in the semiconductor material layer of the second conductivity type is equal to the width of the second electric contact.

19. The solar cell according to claim 17, wherein the opening in the semiconductor material layer of the second conductivity type is larger than the width of the second electric contact.

20. The solar cell according to claim 11 wherein the opening in the intrinsic semiconductor layer (2) of the first electric contacts (E₁) is equal to the opening in the semiconductor material layer (3) of the second conductivity type of the first electric contacts (E₁) and the openings in the intrinsic semiconductor layer and the semiconductor material layer are either equal to, or smaller or larger than a width of the second electric contact (E₂),
wherein a portion of the area of the second electric contact is covered by a passivation layer (8).

21. The solar cell according to claim 20, wherein the passivation layer (8) comprises a passivating material selected from a group consisting of silicon nitride, aluminum oxide, silicon dioxide and amorphous silicon or stacks or combinations thereof.

22. A method for manufacturing a solar cell (M), as recited in claim 1, comprising:
providing a silicon semiconductor substrate (1) of a first conductivity type, the substrate having a front surface (F) and a rear surface (R); arranging the front surface for capturing radiation energy;
creating on the rear surface a plurality of first electric contacts (E₁) and a plurality of second electric contacts, the first and second electric contacts (E₂) being arranged in alternation adjacent to each other, wherein the first electric contact is a heterojunction structure (2,3;3) of first type as contact for minority charge carriers;
creating in the front surface of the silicon semiconductor substrate a highly doped silicon layer (5; 5a, 5b; 5c, 5d; 5e, 5f) as front surface field layer, the conductivity of the front surface field layer being of the first conductivity type, which front surface field layer is arranged for providing a lateral conductance path along the front surface for majority charge carriers..

23. The method according to claim 22, comprising:
arranging the front surface field layer (5; 5a, 5b; 5c, 5d; 5e, 5f) to have a lateral modulation of the resistivity, comprising resistance regions (5a, 5b; 5c, 5d; 5e, 5f) of different resistance as a function of location in the front surface field layer.

## Patentansprüche

1. Solarzelle (M) mit einem Silizium-Halbleitersubstrat (1) eines ersten Leitfähigkeitstyps, wobei das Substrat eine vordere Oberfläche (F) und eine rückwärtige Oberfläche (R) aufweist, wobei die vordere Oberfläche zum Auffangen von Strahlungsenergie vorbereitet ist,
wobei die rückwärtige Oberfläche eine Mehrzahl von ersten elektrischen Kontakten (E1) und eine Mehrzahl von zweiten elektrischen Kontakten (E2) aufweist, wobei die ersten und zweiten elektrischen Kontakte einander abwechselnd benachbart angeordnet sind,
wobei jeder erste elektrische Kontakt eine Heteroübergangsstruktur eines ersten Typs (2, 3; 3) als Kontakt für Minoritätsladungsträger ist,
wobei die vordere Oberfläche des Siliziumsubstrats einen seitlichen Leitfähigkeitsweg entlang der vorderen Oberfläche für Majoritätsladungsträger aufweist, wobei der seitliche Leitfähigkeitsweg durch eine vordere Oberflächenfeldschicht vorgesehen ist, die auf der vorderen Oberfläche des Siliziumsubstrats angeordnet ist, wobei die vordere Oberflächenfeldschicht eine hochdotierte Siliziumschicht (5; 5a, 5b; 5c, 5d; 5e, 5f) ist, wobei die Leitfähigkeit der vorderen Oberflächenfeldschicht vom ersten Leitfähigkeitstyp in der Weise ist, dass der seitliche Leitfähigkeitsweg entlang der vorderen Oberfläche einen relativ niedrigen Widerstand zu Orten der vorderen Oberfläche bietet, die im Wesentlichen oberhalb von entsprechenden zweiten elektrischen Kontakten (E2) liegen, wo die Majoritätsladungsträger das Substrat in einer Richtung im Wesentlichen senkrecht zu der vorderen Oberfläche hin zu den zweiten elektrischen Kontakten durchqueren können.

2. Solarzelle nach Anspruch 1, wobei die Heteroübergangsstruktur des ersten Typs eine Halbleitermaterialschicht (3) eines zweiten Leitfähigkeitstyps aufweist, wobei der zweite Leitfähigkeitstyp dem ersten Leitfähigkeitstyp entgegengesetzt ist, wobei die Halbleitermaterialschicht (3) des zweiten Leitfähigkeitstyps an der rückwärtigen Oberfläche des Substrats angeordnet ist.

3. Solarzelle nach Anspruch 1, wobei die Heteroübergangsstruktur des ersten Typs eine intrinsische Halbleiterschicht (2) und eine Halbleitermaterialschicht (3) eines zweiten Leitfähigkeitstyps aufweist, wobei der zweite Leitfähigkeitstyp dem ersten Leitfähigkeitstyps entgegengesetzt ist, wobei die intrinsische Halbleiterschicht (2) an der rückwärtigen Oberfläche des Substrats angeordnet ist und die Halbleitermaterialschicht (3) des zweiten Leitfähigkeitstyps auf der intrinsischen Halbleiterschicht angeordnet ist.

4. Solarzelle nach Anspruch 3, wobei die intrinsische Halbleiterschicht (2) eine Schicht aus intrinsischem, amorphem Silizium ist.

5. Solarzelle nach Anspruch 1, wobei die Heteroübergangsstruktur des ersten Typs eine dielektrische Schicht und eine Halbleitermaterialschicht (3) eines zweiten Leitfähigkeitstyps aufweist, wobei der zweite Leitfähigkeitstyp dem ersten Leitfähigkeitstyp entgegengesetzt ist, wobei die dielektrische Schicht an der rückwärtigen Oberfläche (R) des Substrats angeordnet ist und die Halbleitermaterialschicht (3) des zweiten Leitfähigkeitstyps auf der dielektrischen Schicht angeordnet ist.

6. Solarzelle nach einem der vorhergehenden Ansprüche 2 bis 5, wobei die Halbleitermaterialschicht (3) des zweiten Leitfähigkeitstyps eine dotierte, amorphe Siliziumschicht des zweiten Leitfähigkeitstyps ist.

7. Solarzelle nach Anspruch 1, wobei die vordere Oberflächenfeldschicht eine seitliche Modulation des spezifischen Widerstands hat, Widerstandsregionen (5a, 5b; 5c, 5d; 5e, 5f) mit verschiedenem Widerstand als Funktion des Ortes an der vorderen Oberflächenfeldschicht aufweist.

8. Solarzelle nach Anspruch 7, wobei die seitliche Modulation des spezifischen Widerstands durch eine Reihe von ersten Zonen (5e) und zweiten Zonen (5f) in der vorderen Oberfläche ausgeführt ist, die benachbart und einander abwechselnd angeordnet sind, wobei jede erste Zone einen niedrigen Widerstand und jede zweite Zone einen relativ höheren Widerstand hat.

9. Solarzelle nach Anspruch 7, wobei die seitliche Modulation des spezifischen Widerstands durch eine vordere Oberflächenfeldschicht mit einer Basisschicht (5c) und lokal dotierten Gebieten (5d) ausgeführt ist, wobei die Basisschicht entlang der vorderen Oberfläche des Substrats verläuft, wobei die lokal dotierten Gebiete entlang der Basisschicht angeordnet sind, wobei die Basisschicht einen Basiswiderstand hat, wobei die Kombination von Basisschicht und lokal dotiertem Gebiet einen relativ niedrigeren Widerstand als der Basiswiderstand der Basisschicht hat.

10. Solarzelle nach Anspruch 1, wobei die zweiten elektrischen Kontakte jeweils durch ein hochdotiertes Gebiet (4) in dem Siliziumhalbleitersubstrat zwischen einem Paar von ersten elektrischen Kontakten ausgeführt sind, wobei das hochdotierte Gebiet den ersten Leitfähigkeitstyp hat.

11. Solarzelle nach Anspruch 10 und Anspruch 3, wobei jeder zweite elektrische Kontakt (E2) innerhalb von Öffnungen (0) der intrinsischen Halbleiterschicht (2) und der Halbleitermaterialschicht (3) des zweiten Leitfähigkeitstyps von benachbarten ersten elektrischen Kontakten (E1) angeordnet ist.

12. Solarzelle nach Anspruch 11, wobei die Öffnung in der intrinsischen Halbleiterschicht (2) der ersten elektrischen Kontakte (E1) gleich der Öffnung in der Halbleitermaterialschicht (3) des zweiten Leitfähigkeitstyps der ersten elektrischen Kontakte (E1) ist.

13. Solarzelle nach Anspruch 12, wobei die Öffnungen in der intrinsischen Halbleiterschicht und der Halbleitermaterialschicht gleich einer Breite des zweiten elektrischen Kontakts (E2) sind.

14. Solarzelle nach Anspruch 11, wobei die Öffnung in der intrinsischen Halbleiterschicht der ersten elektrischen Kontakte kleiner als die Öffnung in der Halbleitermaterialschicht des zweiten Leitfähigkeitstyps der ersten elektrischen Kontakte ist und wobei die Öffnung in der intrinsischen Halbleiterschicht gleich einer Breite (W) des zweiten elektrischen Kontakts ist.

15. Solarzelle nach Anspruch 12, wobei die Öffnungen in der intrinsischen Halbleiterschicht und der Halbleitermaterialschicht größer als eine Breite des zweiten elektrischen Kontakts sind.

16. Solarzelle nach Anspruch 11, wobei die Öffnung in der intrinsischen Halbleiterschicht der ersten elektrischen Kontakte gleich der Öffnung in der Halbleitermaterialschicht des zweiten Leitfähigkeitstyps der ersten elektrischen Kontakte ist und eine Breite des zweiten elektrischen Kontakts größer als die Öffnungen in der intrinsischen Halbleiterschicht und der Halbleitermaterialschicht ist.

17. Solarzelle nach Anspruch 11, wobei die Öffnung in der intrinsischen Halbleitermaterialschicht der ersten elektrischen Kontakte kleiner als eine Breite des zweiten elektrischen Kontakts ist und die Öffnung in der Halbleitermaterialschicht des zweiten Leitfähigkeitstyps der ersten elektrischen Kontakte größer als die Öffnung in der intrinsischen Halbleiterschicht ist.

18. Solarzelle nach Anspruch 17, wobei die Öffnung in der Halbleitermaterialschicht des zweiten Leitfähigkeitstyps gleich der Breite des zweiten elektrischen Kontakts ist.

19. Solarzelle nach Anspruch 17, wobei die Öffnung in der Halbleitermaterialschicht des zweiten Leitfähigkeitstyps größer als die Breite des zweiten elektrischen Kontakts ist.

20. Solarzelle nach Anspruch 11, wobei die Öffnung in der intrinsischen Halbleiterschicht (2) der ersten elektrischen Kontakte (E1) gleich der Öffnung in der Halbleitermaterialschicht (3) des zweiten Leitfähigkeitstyps der ersten elektrischen Kontakte (E1) ist und die Öffnungen in der intrinsischen Halbleiterschicht und der Halbleitermaterialschicht entweder gleich, kleiner oder größer als eine Breite des zweiten elektrischen Kontakts (E2) sind, wobei ein Bereich des Gebiets des zweiten elektrischen Kontakts durch eine Passivierungsschicht (8) bedeckt ist.

21. Solarzelle nach Anspruch 20, wobei die Passivierungsschicht (8) ein Passivierungsmaterial aufweist, das ausgewählt ist aus der Gruppe bestehend aus Siliziumnitrid, Aluminiumoxid, Siliziumdioxid und amorphem Silizium oder Stapelungen oder Kombinationen daraus.

22. Verfahren zum Herstellen einer Solarzelle (M) wie in Anspruch 1 definiert, mit:
Bereitstellen eines Siliziumhalbleitersubstrats (1) eines ersten Leitfähigkeitstyps, wobei das Substrat eine vordere Oberfläche (F) und eine rückwärtige Oberfläche (R) aufweist, Vorbereiten der vorderen Oberfläche zum Auffangen von Strahlungsenergie,
Erzeugen einer Mehrzahl von ersten elektrischen Kontakten (E1) und einer Mehrzahl von zweiten elektrischen Kontakten auf der rückwärtigen Oberfläche, wobei die ersten und zweiten elektrischen Kontakte einander abwechselnd und benachbart angeordnet sind, wobei der erste elektrische Kontakt eine Heteroübergangsstruktur (2, 3; 3) des ersten Typs als Kontakt für Minoritätsladungsträger ist,
Erzeugen in der vorderen Oberfläche des Siliziumhalbleitersubstrats einer hochdotierten Siliziumschicht (5; 5a, 5b; 5c, 5d; 5e, 5f) als vordere Oberflächenfeldschicht, wobei die Leitfähigkeit der vorderen Oberflächenfeldschicht vom ersten Leitfähigkeitstyp ist, wobei die vordere Oberflächenfeldschicht dazu vorbereitet ist, um einen seitlichen Leitfähigkeitsweg entlang der vorderen Oberfläche für Majoritätsladungsträger bereitzustellen.

23. Verfahren nach Anspruch 22, mit:
Vorbereiten der vorderen Oberflächenfeldschicht (5; 5a, 5b; 5c, 5d; 5e, 5f), um eine seitliche Modulation des spezifischen Widerstands zu erhalten, mit Widerstandsregionen (5a, 5b; 5c, 5d; 5e, 5f) mit verschiedenem Widerstand als Funktion des Ortes in der vorderen Oberflächenfeldschicht.

## Revendications

1. Cellule solaire (M) comprenant un substrat semi-conducteur de silicium (1) d'un premier type de conductivité, le substrat ayant une surface avant (F) et une surface arrière (R) ; la surface avant étant disposée pour capter une énergie rayonnante ;
la surface arrière comprenant une pluralité de premiers contacts électriques (E₁) et une pluralité de deuxièmes contacts électriques (E₂), les premiers et deuxièmes contacts électriques étant disposés en alternance adjacents l'un à l'autre,
dans laquelle chaque premier contact électrique est une structure d'hétérojonction d'un premier type (2, 3 ; 3) en tant que contact pour des porteurs de charge minoritaires,
dans laquelle la surface avant du substrat de silicium comprend un chemin de conductance latéral le long de la surface avant pour des porteurs de charge majoritaires, le chemin de conductance latéral étant fourni par une couche de champ de surface avant située sur la surface avant du substrat de silicium, la couche de champ de surface avant étant une couche de silicium fortement dopée (5 ; 5a, 5b ; 5c, 5d ; 5e, 5f), la conductivité de la couche de champ de surface avant étant du premier type de conductivité, de telle manière que le chemin conducteur latéral le long de la surface avant fournisse une résistance relativement basse dans des positions sur la surface avant sensiblement au-dessus de deuxièmes contacts électriques correspondants (E₂) où les porteurs de charge majoritaires peuvent traverser le substrat dans une direction sensiblement perpendiculaire à la surface avant vers lesdits deuxièmes contacts électriques.

2. Cellule solaire selon la revendication 1, dans laquelle la structure d'hétérojonction du premier type comprend une couche de matériau semi-conducteur (3) d'un deuxième type de conductivité, le deuxième type de conductivité étant opposé au premier type de conductivité, dans laquelle la couche de matériau semi-conducteur (3) du deuxième type de conductivité est située sur la surface arrière du substrat.

3. Cellule solaire selon la revendication 1, dans laquelle la structure d'hétérojonction du premier type comprend une couche de semi-conducteur intrinsèque (2) et une couche de matériau semi-conducteur (3) d'un deuxième type de conductivité, le deuxième type de conductivité étant opposé au premier type de conductivité, dans laquelle la couche de semi-conducteur intrinsèque (2) est située sur la surface arrière du substrat et la couche de matériau semi-conducteur (3) du deuxième type de conductivité est située sur le dessus de la couche de semi-conducteur intrinsèque (2).

4. Cellule solaire selon la revendication 3, dans laquelle la couche de semi-conducteur intrinsèque (2) est une couche de silicium amorphe intrinsèque.

5. Cellule solaire selon la revendication 1, dans laquelle la structure d'hétérojonction du premier type comprend une couche diélectrique et une couche de matériau semi-conducteur (3) d'un deuxième type de conductivité, le deuxième type de conductivité étant opposé au premier type de conductivité, dans laquelle la couche diélectrique est située sur la surface arrière (R) du substrat et la couche de matériau semi-conducteur (3) du deuxième type de conductivité est située sur le dessus de la couche diélectrique.

6. Cellule solaire selon l'une quelconque des revendications précédentes 2 à 5, dans laquelle la couche de matériau semi-conducteur (3) du deuxième type de conductivité est une couche de silicium amorphe dopée du deuxième type de conductivité.

7. Cellule solaire selon la revendication 1, dans laquelle la couche de champ de surface avant a une modulation latérale de la résistivité, comprenant des régions de résistance (5a, 5b ; 5c, 5d ; 5e, 5f) de résistance différente en fonction de la position dans la couche de champ de surface avant.

8. Cellule solaire selon la revendication 7, dans laquelle la modulation latérale de la résistivité est mise en oeuvre par une série de premières zones (5c) et de deuxièmes zones (5f) dans la surface avant disposées en alternance adjacentes l'une à l'autre, chaque première zone ayant une résistance plus faible et chaque deuxième zone ayant une résistance relativement plus grande.

9. Cellule solaire selon la revendication 7, dans laquelle la modulation latérale de la résistivité est mise en oeuvre par la couche de champ de surface avant comprenant une couche de base (5c) et des zones dopées locales (5d), la couche de base s'étendant le long de la surface avant du substrat, les zones dopées locales étant disposées le long de la couche de base, la couche de base ayant une résistance de base, la combinaison de couche de base et zone dopée locale ayant une résistance relativement plus faible que la résistance de base de la couche de base.

10. Cellule solaire selon la revendication 1, dans laquelle les deuxièmes contacts électriques sont chacun mis en oeuvre par une zone fortement dopée (4) dans le substrat semi-conducteur de silicium entre une paire de premiers contacts électriques ; la zone fortement dopée ayant le premier type de conductivité.

11. Cellule solaire selon la revendication 10 et la revendication 3, dans laquelle chaque deuxième contact électrique (E₂) est disposé dans des ouvertures (O) de la couche de semi-conducteur intrinsèque (2) et de la couche de matériau semi-conducteur (3) du deuxième type de conductivité de premiers contacts électriques adjacents (E₁).

12. Cellule solaire selon la revendication 11, dans laquelle l'ouverture dans la couche de semi-conducteur intrinsèque (2) des premiers contacts électriques (E₁) est égale à l'ouverture dans la couche de matériau semi-conducteur (3) du deuxième type de conductivité des premiers contacts électriques (E₁).

13. Cellule solaire selon la revendication 12, dans laquelle les ouvertures dans la couche de semi-conducteur intrinsèque et dans la couche de matériau semi-conducteur sont égales à une largeur du deuxième contact électrique (E₂).

14. Cellule solaire selon la revendication 11, dans laquelle l'ouverture dans la couche de semi-conducteur intrinsèque des premiers contacts électriques est plus petite que l'ouverture dans la couche de matériau semi-conducteur du deuxième type de conductivité des premiers contacts électriques, et l'ouverture dans la couche de semi-conducteur intrinsèque est égale à une largeur (W) du deuxième contact électrique.

15. Cellule solaire selon la revendication 12, dans laquelle les ouvertures dans la couche de semi-conducteur intrinsèque et dans la couche de matériau semi-conducteur sont plus grandes qu'une largeur du deuxième contact électrique.

16. Cellule solaire selon la revendication 11, dans laquelle l'ouverture dans la couche de semi-conducteur intrinsèque des premiers contacts électriques est égale à l'ouverture dans la couche de matériau semi-conducteur du deuxième type de conductivité des premiers contacts électriques, et une largeur du deuxième contact électrique est plus grande que les ouvertures dans la couche de semi-conducteur intrinsèque et dans la couche de matériau semi-conducteur.

17. Cellule solaire selon la revendication 11, dans laquelle l'ouverture dans la couche de semi-conducteur intrinsèque des premiers contacts électriques est plus petite qu'une largeur du deuxième contact électrique et l'ouverture dans la couche de matériau semi-conducteur du deuxième type de conductivité des premiers contacts électriques est plus grande que l'ouverture dans la couche de semi-conducteur intrinsèque.

18. Cellule solaire selon la revendication 17, dans laquelle l'ouverture dans la couche de matériau semi-conducteur du deuxième type de conductivité est égale à la largeur du deuxième contact électrique.

19. Cellule solaire selon la revendication 17, dans laquelle l'ouverture dans la couche de matériau semi-conducteur du deuxième type de conductivité est plus grande que la largeur du deuxième contact électrique.

20. Cellule solaire selon la revendication 11, dans laquelle l'ouverture dans la couche de semi-conducteur intrinsèque (2) des premiers contacts électriques (E₁) est égale à l'ouverture dans la couche de matériau semi-conducteur (3) du deuxième type de conductivité des premiers contacts électriques (E₁) et les ouvertures dans la couche de semi-conducteur intrinsèque et dans la couche de matériau semi-conducteur sont égales à ou plus petites ou plus grandes qu'une largeur du deuxième contact électrique (E₂),
dans laquelle une portion de la surface du deuxième contact électrique est recouverte par une couche de passivation (8).

21. Cellule solaire selon la revendication 20, dans laquelle la couche de passivation (8) comprend un matériau de passivation sélectionné dans un groupe comprenant le nitrure de silicium, l'oxyde d'aluminium, le dioxyde de silicium et le silicium amorphe ou des empilements ou combinaisons de ceux-ci.

22. Procédé de fabrication d'une cellule solaire (M), selon la revendication 1, comprenant :
la fourniture d'un substrat semi-conducteur de silicium (1) d'un premier type de conductivité, le substrat ayant une surface avant (F) et une surface arrière (R) ; la disposition de la surface avant pour capter une énergie rayonnante ;
la création sur la surface arrière d'une pluralité de premiers contacts électriques (E₁) et d'une pluralité de deuxièmes contacts électriques, les premiers et deuxièmes contacts électriques (E₂) étant disposés en alternance adjacents l'un à l'autre, dans lequel le premier contact électrique est une structure d'hétérojonction (2, 3 ; 3) d'un premier type en tant que contact pour des porteurs de charge minoritaires ;
la création dans la surface avant du substrat semi-conducteur de silicium d'une couche de silicium fortement dopée (5 ; 5a, 5b ; 5c, 5d ; 5e, 5f) comme couche de champ de surface avant, la conductivité de la couche de champ de surface avant étant du premier type de conductivité, laquelle couche de champ de surface avant est disposée pour fournir un chemin conducteur latéral le long de la surface avant pour des porteurs de charge majoritaires.

23. Procédé selon la revendication 22, comprenant :
la disposition de la couche de champ de surface avant (5 ; 5a, 5b ; 5c, 5d ; 5e, 5f) pour avoir une modulation latérale de la résistivité, comprenant des régions de résistance (5a, 5b ; 5c, 5d ; 5e, 5f) de résistance différente en fonction de la position dans la couche de champ de surface avant.
